# EUROPÄISCHE PATENTSCHRIFT

(11) **EP 0 337 268 B1**
(45) Veröffentlichungstag und Bekanntmachung des Hinweises auf die Patenterteilung: **21.07.1993**
(21) Anmeldenummer: 89105934.7
(22) Anmeldetag: 05.04.1989
(51) Int. Cl.: H03C 3/09

(54) **Frequenzmodulationsverfahren sowie Anordnung**
Frequency modulaton method and system
Procédé de modulation en fréquence et montage

(30) Priorität: 14.04.1988 DE 3812383
(43) Veröffentlichungstag der Anmeldung: 18.10.1989
(73) Patentinhaber: ANT Nachrichtentechnik GmbH, D-71522 Backnang (DE)
(72) Erfinder: Drinda, Klaus, Dipl.-Ing., D-7150 Backnang (DE)

(56) Entgegenhaltungen:
- EP-A- 0 250 274
- EP-A- 0 250 274
- DE-A- 2 637 953
- FR-A- 2 574 242

## Beschreibung

Die Erfindung betrifft ein Frequenzmodulationsverfahren gemäß dem Oberbegriff des Patentanspruchs 1 sowie Anordnungen hierzu.

Aus der DE-C-26 37 953 ist eine Einrichtung zum Nachstimmen eines Oszillators bekannt, bei der ein Modulationssignal und ein Referenzsignal jeweils nach Frequenzteilung mittels eines Phasendiskriminators miteinander verglichen werden. Aus dem Ausgangssignal des Phasendiskriminators wird dort ein Nachstimmsignal für einen Oszillator gewonnen. Über einen Fenstertrigger wird das Nachstimmsignal überwacht und die Erzeugung von Rückstellimpulsen für die Frequenzteiler vorgenommen.

Aufgabe der Erfindung ist es, ausgehend vom Oberbegriff des Patentanspruchs 1, ein Frequenzmodulationsverfahren anzugeben, das auch für Signale geeignet ist, welche einen nicht mittelwertfreien Anteil enthalten. Außerdem soll eine Anordnung zum Durchführen dieses Verfahrens aufgezeigt werden. Diese Aufgabe wird bezüglich des Verfahrens durch die Merkmale des Patentanspruchs 1 und bezüglich der Anordnung durch Merkmale des Anspruchs 6 gelöst. Die Patentansprüche 2 bis 5 betreffen Weiterbildungen des Verfahrens und die Patentansprüche 7 bis 9 Weiterbildungen der Anordnung.

Das Verfahren nach der Erfindung eignet sich insbesondere zur Modulation von D2-MAC Signalen oder ähnlichen Signalen mit nicht mittelwertfreien Signalanteilen. Die Nachstimmung auf die Mittenfrequenz bei der Frequenzmodulation ist immer optimal, da keine Abhängigkeit vom Gleichanteil des modulierenden Signals besteht. Eine Trägerenergieverwischung, die häufig bei der FM-Übertragung über Satelliten angewendet wird, wird nicht nachteilig beeinträchtigt. Die Nachregelung beim Verfahren nach der Erfindung ist modulationshubunabhängig, da auf den Mittelwert des gleichspannungsfreien Signalanteils nachgeregelt wird.

Anhand der Zeichnungen wird ein Ausführungsbeispiel der Erfindung nun näher erläutert. Es zeigen
- Fig. 1: ein Blockschaltbild zur Erzeugung des Nachstimmsignals,
- Fig. 2: das Blockschaltbild eines FM-Modulators.

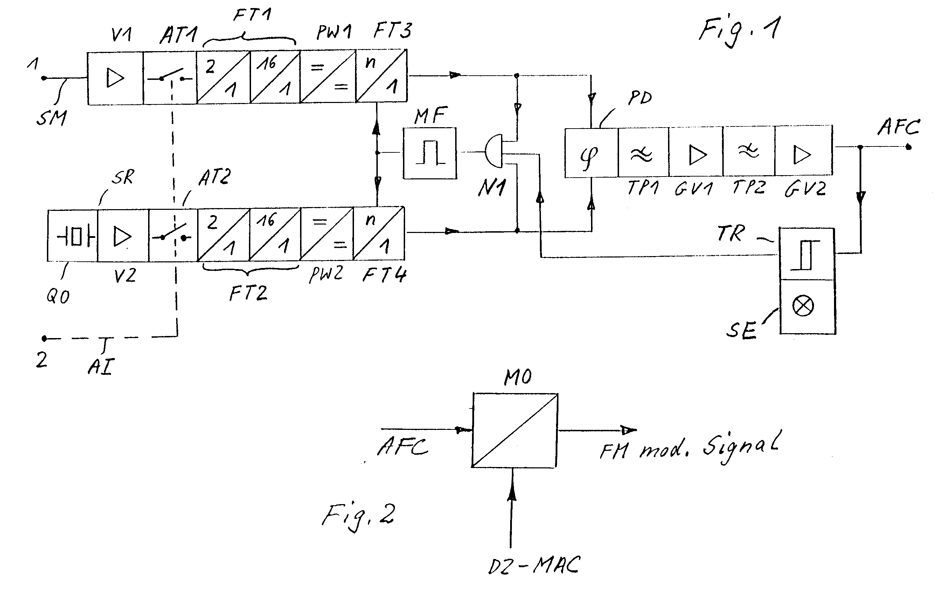

Zur Erzeugung des Nachstimmsignals für einen Modulator wird gemäß Fig. 1 ein Frequenz-/Phasenvergleich eines Modulationssignals SM und eines Referenzsignals SR mittels eines Phasendiskriminators PD vorgenommen. Das Modulationssignal SM, beispielsweise ein 70 MHz ZF-Signal, wird bei Punkt 1 zugeführt. Das Referenzsignal SR wird durch einen quarzgesteuerten Oszillator QO mit beispielsweise 70 MHz erzeugt. Das Modulationssignal SM und das Referenzsignal SR wird jeweils einem gegengekoppelten Verstärker V1, bzw. V2 zugeführt. Diesen Verstärkern V1 und V2 sind jeweils Signalaustaster AT1 und AT2 nachgeschaltet. Die Signalaustaster AT1 und AT2 sind vorteilhafterweise als NAND-Gatter ausgebildet. Die Signalaustaster AT1 und AT2 können durch einen Austastimpuls AI, der an Punkt 2 zugeführt wird, gesperrt werden; d.h. an ihren Ausgängen erscheinen keine 70 MHz-Signale während des Auftretens des Austastimpulses AI. Bei Ausbleiben des Austastimpulses AI sind die beiden 70 MHz-Signale durchgeschaltet. An die Signalaustaster schließen sich jeweils Frequenzteiler FT1 und FT2 an mit einem Teilerverhältnis von 32:1. Diese Frequenzteiler lassen sich durch übliche hochfrequenzverarbeitende Flip-Flops realisieren. Nachgeschaltete Potentialwandler PW1 und PW2 dienen zur Ansteuerung weiterer Frequenzteiler FT3 und FT4 mit einem Teilerverhältnis 2ⁿ:1, wobei n beispielsweise zu 21 gewählt wird. Der Frequenzdiskriminator PD vergleicht die Zahl der positiven Flanken der von den Frequenzteilern FT3 und FT4 abgegebenen Rechtecksignalen. Die am Ausgang des Phasenkomparators PD erhaltenen Impulse werden über Tiefpaßglieder TP1 und TP2 sowie jeweils an den Ausgängen dieser Tiefpaßfilter angeordneten Gleichspannungsverstärkern GV1 und GV2 geführt. Die Tiefpaßglieder dienen zur Aufintegration der vom Phasendiskriminator PD abgegebenen Impulse und zur Unterdrückung von Störfrequenzen. Am Ausgang 3 steht ein Nachstimmsignal zur Verfügung, welches eine zur Frequenzabweichung des Modulationssignals SM vom Referenzsignal SR proportionale Spannung aufweist. Es wird dem in Fig. 2 dargestellten Modulator als AFC-Nachstimmspannung zugeführt. Über ein Monoflop MF, dem jeweils die Ausgangsimpulse der Frequenzteiler FT3 und FT4 über das NAND-Gatter N1 zugeführt werden, können die Frequenzteiler FT3 und FT4 nach jedem Vergleichstakt auf Null zurückgestellt werden. Ein Fenstertrigger TR am Ausgang des Phasendiskriminators PD überwacht die Höhe der Nachstimmspannung. Wenn eine Bereichsüberschreitung vorliegt, d.h. wenn die Nachstimmspannung unzulässige Werte annimmt, werden die Rückstellimpulse für die Frequenzteiler FT3 und FT4 durch das NAND-Gatter N1 unterdrückt. Die Bereichsüberschreitung kann durch eine an den Fenstertrigger TR angeschlossene Signalisiereinheit SE angezeigt werden.

Dem in Fig. 2 dargestellten FM-Modulator MO wird das AFC-Nachstimmsignal vom Phasendiskriminator sowie das zu modulierende Signal, z.B. ein D2-MAC Signal zugeführt. Am Ausgang des Modulators erscheint ein mit dem D2-MAC Signal FM moduliertes und mit dem AFC Signal in der Mittenfrequenz nachgeregeltes Trägersignal, z.B. ein 70 MHz ZF Signal. Als FM-Modulator kann ein für D2-MAC Signale geeigneter Modulator mit DC-Kopplung verwendet werden. Die AFC-Regelung wird so eingestellt, daß während der Signalaustastung eine Frequenzregelung auf den Mittelwert des D2-Signalanteils oder den Pegel der Klemmperiode erfolgt.

Der Austastimpuls AI kann direkt von der D2-MAC Signalerzeugung oder einer D2-MAC Synchronisationsschaltung abgeleitet werden. Er wird vorteilhafterweise genauso lang gewählt wie die Dauer des nicht mittelwertfreien MAC-Anteils im D2-MAC Signal.

## Patentansprüche

1. Frequenzmodulationsverfahren, wobei ein Modulationssignal (SM) und ein Referenzsignal (SR) bezüglich ihrer Frequenz oder Phase zur Bildung eines Nachstimmsignals für einen Modulator (MO) verglichen werden,
dadurch gekennzeichnet,
daß während der Modulation des Modulationssignals mit einem nicht mittelwertfreien Nutzsignalanteil, beispielsweise dem MAC-Anteil eines D2-MAC Signals, der Frequenzvergleich / Phasenvergleich (PD) unterdrückt wird.

2. Verfahren nach Anspruch 1,
dadurch gekennzeichnet,
daß die Unterdrückung des Frequenzvergleichs / Phasenvergleichs (PD) durch eine Signalaustastung (AT1, AT2) sowohl des Modulationssignals (SM) als auch des Referenzsignals (SR) vor dem Frequenzvergleich / Phasenvergleich (PD) vorgenommen wird, wobei die Dauer der Signalaustastung (AT1, AT2) entsprechend der Dauer des nicht mittelwertfreien Nutzsignalanteils gewählt wird.

3. Verfahren nach Anspruch 2,
dadurch gekennzeichnet,
daß das Referenz- (SR) und das Modulationssignal (SM) nach der Signalaustastung (AT1, AT2) und vor dem Frequenz- / Phasenvergleich (PD) in der Frequenz geteilt werden.

4. Verfahren nach einem der Ansprüche 1 bis 3,
dadurch gekennzeichnet,
daß bei der Modulation eines D2-MAC Signals während der Signalaustastung eine Frequenzregelung auf den Mittelwert des D2-Signalanteils vorgenommen wird.

5. Verfahren nach einem der Ansprüche 1 bis 3,
dadurch gekennzeichnet,
daß bei der Modulation eines D2-MAC Signals während der Signalaustastung eine Frequenzregelung auf den Pegel der Klemmperiode vorgenommen wird.

6. Anordnung zum Durchführen des Verfahrens nach einem der Ansprüche 1 bis 5,
gekennzeichnet durch:
- einen ersten Signalaustaster (AT1) zwischen der Modulationssignalzuführung (SM) und einem ersten Eingang eines Phasendiskriminators (PD),
- einen zweiten Signalaustaster (AT2) zwischen der Referenzsignalzuführung (SR) und einem zweiten Eingang des Phasendiskriminators (PD),
- einen Modulator (MO) mit einem Frequenz-Steuereingang, der mit dem Ausgang des Phasendiskriminators (PD) verbunden ist, wobei Mittel vorgesehen sind, mit denen die Signalaustaster (AT1, AT2) so gesteuert werden, daß während der Modulation des Modulationssignals mit einem nicht mittelwertfreien Nutzsignalanteil, beispielsweise dem MAC-Anteil eines D2-MAC Signals, der Frequenzvergleich / Phasenvergleich (PD) unterdrückt wird.

7. Anordnung nach Anspruch 6,
gekennzeichnet durch:
- Frequenzteiler (FT1, FT2, FT3, FT4) zwischen den Signalaustastern (AT1, AT2) und dem Phasendiskriminator (PD).

8. Anordnung nach Anspruch 6 oder 7,
gekennzeichnet durch:
- NAND-Gatter als Signalaustaster (AT1, AT2).

9. Anordnung nach einem der Ansprüche 6 bis 8,
gekennzeichnet durch:
- einen Fenstertrigger (TR) zur Überwachung des Nachstimmsignals,
- einer Logikschaltung (N1), die bei Bereichsüberschreitung des Nachstimmsignals in Abhängigkeit des Fenstertriggers (TR) Rückstellimpulse für die Frequenzteiler (FT3, FT4) unterdrückt.

## Claims

1. Frequency modulation method, wherein a modulation signal (SM) and a reference signal (SR) are compared with respect to their frequency or phase for the formation of a trimming signal for a modulator (MO), characterised thereby that during the modulation of the modulation signal by an information signal component not free of mean value, for example the MAC component of a D2-MAC signal, the frequency comparision/phase comparison (PD) is suppressed.

2. Method according to claim 1, characterised thereby that the suppression of the frequency comparison/phase comparison (PD) is undertaken by a signal blanking (AT1, AT2) not only of the modulation signal (SM) but also of the reference signal (SR) before the frequency comparison/phase comparison (PD), wherein the duration of the signal blanking (AT1, AT2) is selected in accordance with the duration of the information signal component not free of mean value.

3. Method according to claim 2, characterised thereby that the reference signal (SR) and the modulation signal (SM) are divided in frequency after the signal blanking (AT1, AT2) and before the frequency comparison/phase comparison (PD).

4. Method according to one of claims 1 to 3, characterised thereby that in the case of modulation of a D2-MAC signal a frequency regulation to the mean value of the D2 signal component is undertaken during the signal blanking.

5. Method according to one of claims 1 to 3, characterised thereby that in the case of modulation of a D2-MAC signal a frequency regulation to the level of the clamping period is undertaken during the signal blanking.

6. Arrangement for the carrying out of the method according to one of claims 1 to 5, characterised by:
- a first signal blanking device (AT1) between the modulation signal feed (SM) and a first input of a phase discriminator (PD),
- a second signal blanking device (AT2) between the reference signal feed (SR) and a second input of the phase discriminator (PD),
- a modulator (MO) with a frequency control input which is connected with the output of the phase discriminator (PD),
wherein means are provided by which the signal blanking devices (AT1, AT2) are so controlled that during the modulation of the modulation signal by an information signal component not free of mean value, for example the MAC component of a D2-MAC signal, the frequency comparison/phase comparison (PD) is suppressed.

7. Arrangement according to claim 6, characterised by:
- frequency dividers (FT1, FT2, FT3, FT4) between the signal blanking devices (AT1, AT2) and the phase discriminator (PD).

8. Arrangement according to claim 6 or 7, characterised by:
- NAND gates as signal blanking devices (AT1, AT2).

9. Arrangement according to one of claims 6 to 8, characterised by:
- a window trigger (TR) for the monitoring of the trimming signal,
- a logic circuit (N1) which, on exceeding of range by the trimming signal, suppresses resetting pulses for the frequency dividers (FT3, FT4) in dependence on the window trigger (TR).

## Revendications

1. Procédé de modulation en fréquence dans lequel on compare un signal modulant (SM) et un signal de référence (SR) du point de vue de leur fréquence ou de leur phase pour former un signal de reprise d'accord pour un modulateur (MO),
procédé caractérisé
par le fait qu'au cours de la modulation du signal modulant à composante utile de valeur moyenne non nulle du signal, par exemple de la composante MAC d'un signal D2-MAC, on supprime la comparaison en fréquence/la comparaison en phase (PD).

2. Procédé selon la revendication 1,
caractérisé
par le fait que l'on procède à la suppression de la comparaison en fréquence/de la comparaison en phase (PD) au moyen d'un échantillonnage (AT1, AT2) aussi bien du signal modulant (SM) que du signal de référence (SR) avant la comparaison en fréquence/comparaison en phase (PD), la durée de l'échantillonnage du signal (AT1, AT2) étant choisie correspondant à la durée de la composante utile, de valeur moyenne non nulle, du signal.

3. Procédé selon la revendication 2,
caractérisé
par le fait que l'on divise en fréquence le signal de référence (SR) et le signal modulant (SM) après l'échantillonnage du signal (AT1, AT2) et avant la comparaison en fréquence/en phase (PD).

4. Procédé selon l'une des revendications 1 à 3,
caractérisé
par le fait que dans le cas de la modulation d'un signal D2-MAC on procède, pendant l'échatillonnage du signal, à une régulation en fréquence sur la valeur moyenne de la composante D2 du signal.

5. Procédé selon l'une des revendications 1 à 3,
caractérisé
par le fait que dans le cas de la modulation d'un signal D2-MAC on procède, pendant l'échantillonnage du signal, à une régulation en fréquence sur le niveau de la période de suppression de comparaison.

6. Dispositif pour la mise en oeuvre du procédé selon l'une des revendications 1 à 5,
caractérisé par
- un premier échantillonneur du signal (AT1) placé entre l'arrivée du signal modulant (SM) et une première entrée d'un discriminateur de phase (PD),
- un second échantillonneur du signal (AT2) placé entre l'arrivée du signal de référence (SR) et une seconde entrée du discriminateur de phase (PD),
- un modulateur (MO) dont une entrée est pilotée en fréquence et qui est relié à la sortie du discriminateur de phase (PD), étant précisé qu'il est prévu des moyens avec lesquels les échantillonneurs du signal (AT1, AT2) sont pilotés de façon que la comparaison en fréquence/comparaison en phase (PD) soit interrompue au cours de la modulation du signal modulant à composante util de valeur non nulle du signal, par exemple de la composante MAC d'un signal D2-MAC.

7. Dispositif selon la revendication 6,
caractérisé par
- des diviseurs de fréquence (FT1, FT2, FT3, FT4) placés entre les échantillonneurs du signal (AT1, AT2) et le discriminateur de phase (PD).

8. Dispositif selon la revendication 6 ou 7,
caractérisé par
- des portes NON ET comme échantillonneurs du signal (AT1, AT2).

9. Dispositif selon l'une des revendications 6 à 8,
caractérisé par
- une bascule électronique à bande étroite (TR) pour surveiller le signal de reprise d'accord,
- un circuit logique (N1) qui, en cas de dépassement de zone du signal de reprise d'accord, dépassement signalé par la bascule électronique à bande étroite (TR), supprime les impulsions de rappel pour les diviseurs de fréquence (FT3, FT4).
